# EUROPEAN PATENT SPECIFICATION

(11) **EP 0 637 754 B1**
(45) Date of publication and mention of the grant of the patent: **25.09.2002**
(21) Application number: 94904766.6
(22) Date of filing: 25.01.1994
(51) Int. Cl.: G01R 31/36

(54) **BATTERY CAPACITY METER**
INSTRUMENT ZUM MESSEN DER KAPAZITÄT EINER BATTERIE
INSTRUMENT DE MESURE DE CAPACITE POUR BATTERIE

(30) Priority: 27.01.1993 JP 1196693; 27.05.1993 JP 12630993
(43) Date of publication of application: 08.02.1995
(73) Proprietor: SEIKO EPSON CORPORATION, Tokyo 160-0811 (JP)
(72) Inventor: KOUZAKI, Minoru,, Suwa-shi Nagano 392 (JP); YAMAZAKI, Toshihiko,, Suwa-shi Nagano 392 (JP); MARRITT, William, A.,, Suwa-shi Nagano 392 (JP)
(74) Representative: Lehn, Werner, Dipl.-Ing.
(86) International application number: JP9400098
(87) International publication number: WO94017425

(56) References cited:
- EP-A- 0 388 523
- DE-A- 3 624 781
- DE-A- 3 736 481
- JP-A- 56 148 076
- JP-A- 62 237 370
- JP-B- 51 017 699

## Description

### Technical Field

This invention relates to a remaining capacity meter of a battery to be used as a driving source for electric motor vehicles, and particularly to a battery remaining capacity meter with which a usable capacity of the battery being used can be easily understood.

### Background Art

A battery is generally used as a driving source for an electric motor in an electric motor vehicle such as an electric car. Several different methods are known for detecting the remaining capacity of the battery. Such methods can be classified into either 1) direct detection or 2) indirect detection of the remaining capacity.

Specifically, the first classification uses the relationship between the following essential battery characteristics and the battery remaining capacity. These characteristics include the open circuit voltage. electrolyte density, the electrode potential of a pair of reference electrodes, the pH value of the electrolyte. partial pressures of various gases in the cell, relative humidity in the cell dead space, the electrolyte viscosity, and the refractive index of the electrolyte.

A numerical formula representing the relation between these characteristics and the remaining capacity varies depending on the type of battery. Specifically, a sealed lead acid battery is generally recognized to have a linear correlation between the remaining capacity and the open circuit voltage. For example, in a 30-Ah sealed lead acid battery, a 13V open circuit voltage corresponds to 27Ah, 12.4V to 15Ah, and 11.8V to 2Ah. A remaining capacity meter using this correlation is described in detail in Japanese Patent Application Laid-open Print No. 57-149144.

An apparatus based on the relation between the density and the refractive index of the sulfuric acid electrolyte of a lead acid battery has also been used widely to detect the remaining capacity (e.g.. Japanese Patent Application Laid-open Print No. 63-274064 and Japanese Patent Application Laid-open Print No. 1-260769). According to this method, a special probe is inserted into the battery to measure the refractive index of the sulfuric acid electrolyte. The remaining capacity is calculated from the detected values.

The second classification, indirect detection of a remaining capacity, calculates a remaining capacity by measuring either the output current of the battery or the output current and voltage of the battery when the battery is being used as an energy source. This detection method mainly uses the well known PEUKERT equation, InT=C. In the formula, I stands for the discharge current, n for a value larger than 1 which depends on the type of battery, t for the discharge time, and C for a constant. The PEUKERT equation yields values which correspond to the well-known phenomenon in which battery capacity decreases as the electric current increases. For example, in a 30Ah sealed lead acid battery, a 10A constant current discharge leads to a capacity of 26.6Ah, 50A to 17.0Ah, and 80A to 14. 9Ah.

Several remaining capacity meters have been published, which measure battery current, convert the detected output current value using the PEUKERT equation, and integrate the converted value with respect to time (e.g., Japanese Patent Application Laid-open No. 59-56177 and NASA Technical Note D-5773, 1970).

A second indirect detection technique for determining battery remaining capacity uses the output current and the voltage of the battery (e.g., Japanese Patent Application Laid-open No. 2-247588). Specifically, in a table showing current on the horizontal axis and a voltage on the vertical axis, values corresponding to actual battery remaining capacities are indicated, and the table including these values is stored in a memory device which is a component of the remaining capacity meter.

However, the above techniques for measuring the remaining capacity of a battery are not appropriate for conditions of actual use and have limitations with respect to accuracy and cost which remain to be solved.

Specifically, the direct detection technique which uses the open circuit voltage shows a correct value only when reaching an equilibrium voltage after an extended period of time. However, when an electric motor vehicle such as an electric car actually runs in an urban area, it does not stop for long enough periods of time for the battery to reach the equilibrium voltage. As a result, the correct remaining value cannot be determined under these conditions.

In the method for measuring the refractive index of the electrolyte with a sensor, the insertion of the sensor for measuring the refractive index is expensive and has the disadvantage of increasing the possibility of electrolyte leakage from the point of sensor insertion. Additionally. it is difficult to position the sensor at an appropriate location within the battery such that a representative value can be measured.

Furthermore, a method for detecting a remaining capacity, which uses the PEUKERT equation to covert an input current signal, integrates the used battery capacity, and subtracts the integrated used capacity from the whole capacity, requires complicated circuitry which is expensive.

It also has the disadvantage that large errors can occur under ordinary conditions of battery use. The errors of this method are cumulative and, thus, tend to increase with respect to the time of battery use. This tendency becomes particularly significant when the conditions of using the battery change drastically and frequently.

To minimize the accumulation of errors, it is known in the art to provide a reset switch with which the battery remaining capacity meter resets to zero when the battery is fully charged. For a battery which is determined to be in a fully charged state when charged, the reset switch is triggered after charging is completed to initialize the battery remaining capacity meter and eliminate any previously accumulated errors.

However, when a battery is partly charged, e.g. up to 60% of the total capacity by a quick charger, the reset switch is not triggered and accumulated errors remain. To minimize the accumulated errors, accurate integration of the reverse current during charging is necessary. But, since it is very hard to precisely execute integration of the reverse current, unacceptable errors can accumulate. The reason for this is that the charging efficiency of a battery is not constant and varies depending on the temperature and the charging conditions, so that the current fraction used for actual charging of the battery cannot be determined accurately. Furthermore, repetition of partial charging and discharging without triggering the reset switch may result in accumulated error which is unacceptable such that the remaining capacity meter may become useless.

Another problem with this method is that even when the battery has available remaining capacity, it may not be used for high current values because of large voltage drops. In this case, although the battery cannot be used because of the large voltage drops at that time, after a lapse of a certain time, the battery recovers and it may be used for high current values. In this case, the integration method indicates before and after recovery that there is no remaining capacity, causing the user to be confused. And, even if it is technically not an error, the remaining state of the battery is not indicated properly for both conditions, before and after recovery. That is to say, under the present method which uses the battery current, there is a disadvantage that the usable battery remaining capacity under all situations cannot be determined accurately.

In the aforementioned indirect detecting method (a method using a table based on the output current value and the voltage value of a battery), a remaining capacity can be estimated very accurately. However, with each value in the table representing an actual capacity value, the positional interval between a full charge indication and an empty charge indication will vary with the magnitude of the battery current used as indicated by the PEUKERT equation. Therefore, depending on the way in which the full charge state or empty charge state is defined, the indicating device either 1) indicating a capacity which varies greatly with the increase or decrease of current used or 2) indicates that remaining capacity can be used even when it cannot be used. In either case, the user has difficulty in understanding the indication of battery remaining capacity.

In view of the circumstances, this invention has been completed with the aim of realizing a battery remaining capacity meter using an inexpensive circuit structure, which can always make measurements regardless of the presence of a load, automatically corrects for differences in battery capacity due to the magnitude of a discharge current value. and always indicates a remaining capacity with respect to the current discharge current value. Furthermore, the capacity indication of the battery remaining capacity meter is designed to be similar to that of a fuel meter used in conventional internal combustion engine cars, so that the user can easily understand it.

### Disclosure of the Invention

This invention provides a battery remaining capacity meter which comprises: a detecting means for detecting the discharge current and the terminal voltage of a battery, a data table of remaining capacity values of the battery, each of which corresponds to a respective combination of a discharge current and a terminal voltage, and in which the remaining capacity values are based on actual measurements, a memory for storing the above data table, and an indicating means for reading the remaining capacity value from the memory using the current value and the terminal voltage value of the operating battery and for controlling a display, wherein: the remaining capacity value defined as a percentage of the capacity of the battery in a fully charged state thereof is set as a ratio between a total time during which a constant current discharge can be made from an initial voltage in a fully charged state to an end voltage and a remaining time during which the constant current discharge can be made from the detected terminal voltage value to the end voltage.

### Brief Description of the Drawings

[Fig. 1]
   A schematic view showing the entire circuit structure of the battery remaining capacity meter according to Example 1 of the invention.
[Fig. 2]
   A front view showing the appearance of the display of Example 1.
[Fig. 3]
   A data table stored in the memory, ROM, of Example 1.
[Fig. 4]
   An explanatory view showing the relation between a discharge curve at each current value and a graph representing the data table of Example 1.
[Fig. 5]
   A data table stored in the memory, ROM, according to Example 2 of the invention.
[Fig. 6]
   A data table stored in the memory, ROM, according to Example 3 of the invention.
[Fig. 7]
   A data table stored in the memory, ROM, according to Example 4 of the invention.
[Fig. 8]
   A data table stored in the memory, ROM, according to Comparative Example 1.
[Fig. 9]
   A data table of battery absolute capacity values at each measured current value according to Comparative Example 2 (unusable capacities are included in this table).
[Fig. 10]
   A data table stored in the memory, ROM, according to Comparative Example 2.
[Fig. 11]
   A diagrammatic view showing a constant current discharge characteristic of an ordinary battery.
[Fig. 12]
   A characteristic view showing each discharge curve at different constant current discharges.
[Fig. 13]
   A characteristic view showing the relation between a battery discharge current value and a dischargeable capacity.
[Fig. 14]
   A characteristic view showing the relation between a battery discharge voltage and a dischargeable capacity based on the discharge curve at a given constant current discharge.
[Fig. 15]
   A data table of battery absolute capacity values usable at each measured current value according to the invention.

### Best Mode for Carrying Out the Invention

Prior to describing examples, known discharging characteristics of batteries will be described to make it easy to understand the invention.

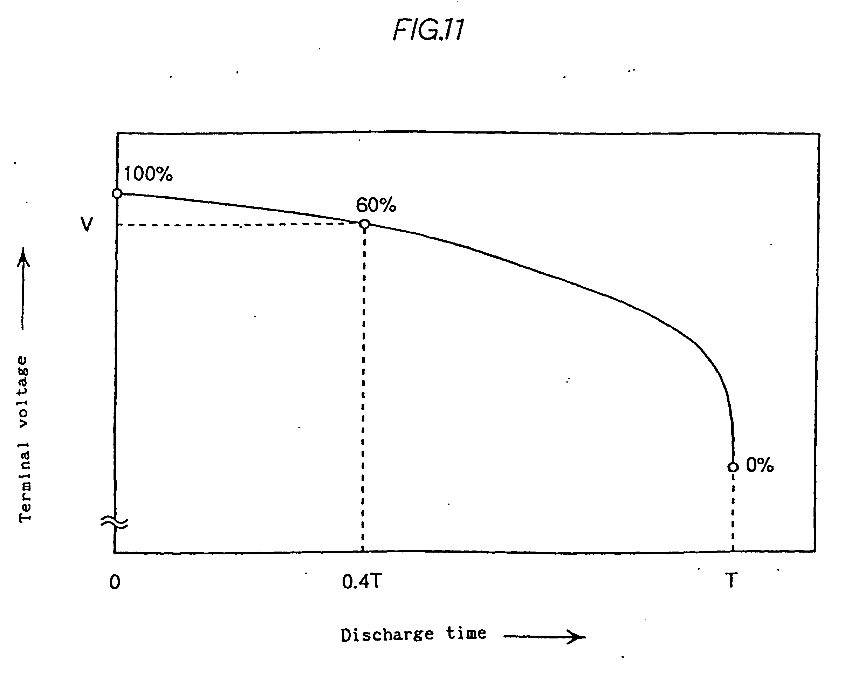

First, for example, when a sealed lead acid battery having a nominal capacity of 30Ah is discharged at a constant current from a fully charged state to the last stage of discharge, the battery terminal voltage varies with the respect to the discharge time, as shown in Fig. 11. Specifically, as shown in the figure, the terminal voltage decreases gradually for most of the discharge time, then decreases sharply at a time T when the usable capacity of the battery is exhausted. Therefore, the discharge capacity usable at a certain time for this discharge condition can be represented by the product of the discharge current and the elapsed time up until the voltage drop point T.

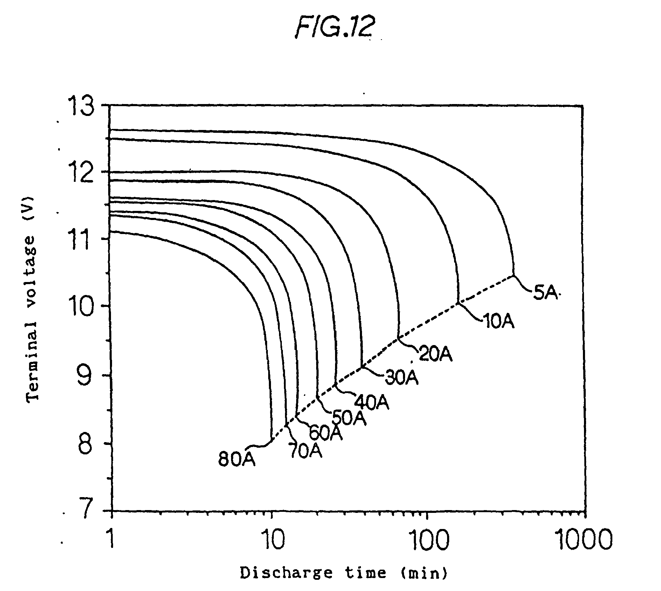

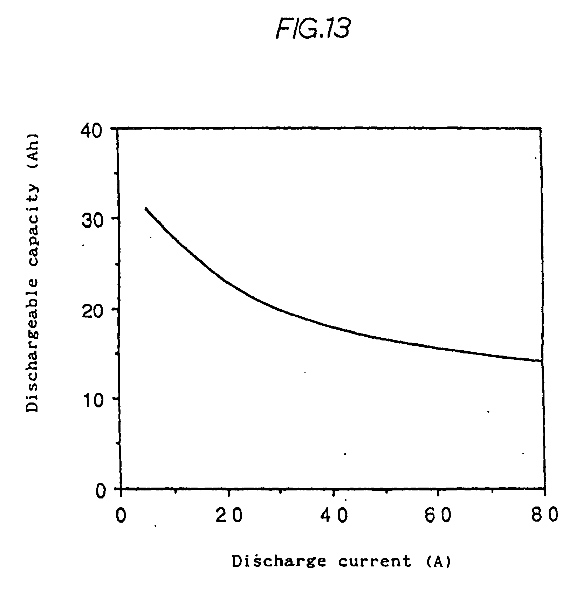

Second, it is known according to the PEUKERT equation that the discharge time is shortened as the constant-current discharge value increases. Specifically, as shown in Fig. 12, the time T at which the voltage drops sharply decreases significantly with the increase of the constant current discharge. Furthermore, the voltage at the time T also tends to decrease. Accordingly, as the discharge current increases, the dischargeable capacity decreases, and the discharge curves become different. As a result, when a fully charged battery is discharged at several different constant currents, the whole dischargeable capacity varies according to the current, and the dischargeable capacity can be determined as a function of each constant current. Specifically, as shown in Fig. 13, for example in the same battery having a nominal capacity of 30Ah, the dischargeable capacity decreases as the discharge current value increases.

At a certain constant current, a discharge curve can be drawn using capacity instead of time on the horizontal axis and the terminal voltage on the vertical axis. Division of the voltage axis into several small ranges can generate the vertical component of a table which relates the dischargeable remaining capacity at a given time with the terminal voltage and the discharge current of the battery.

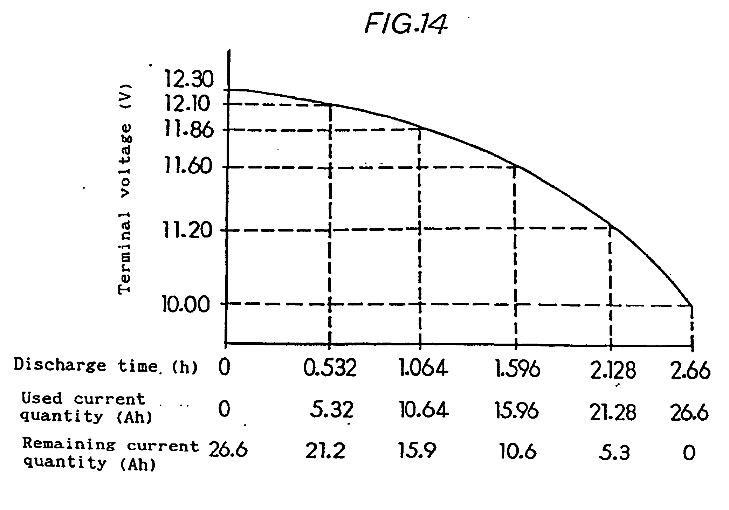

Specifically, as shown in Fig. 14, at a discharge current of 10A for example, a range from zero to time T on the horizontal axis is divided into five sections, so that a voltage range corresponding to each divided section can be obtained. Specifically, from the 10A discharge current value and the elapsed time to a certain divided time on the horizontal axis, the used current quantity (Ah) at this time can be calculated. And, by subtracting the used current value at each time from the whole used current value (Ah) calculated from the total elapsed time of discharging, the absolute remaining capacity value usable at each time can be obtained. By conducting this operation at every other current A, a table for obtaining usable absolute remaining capacity from each discharge current and measured voltage can be prepared.

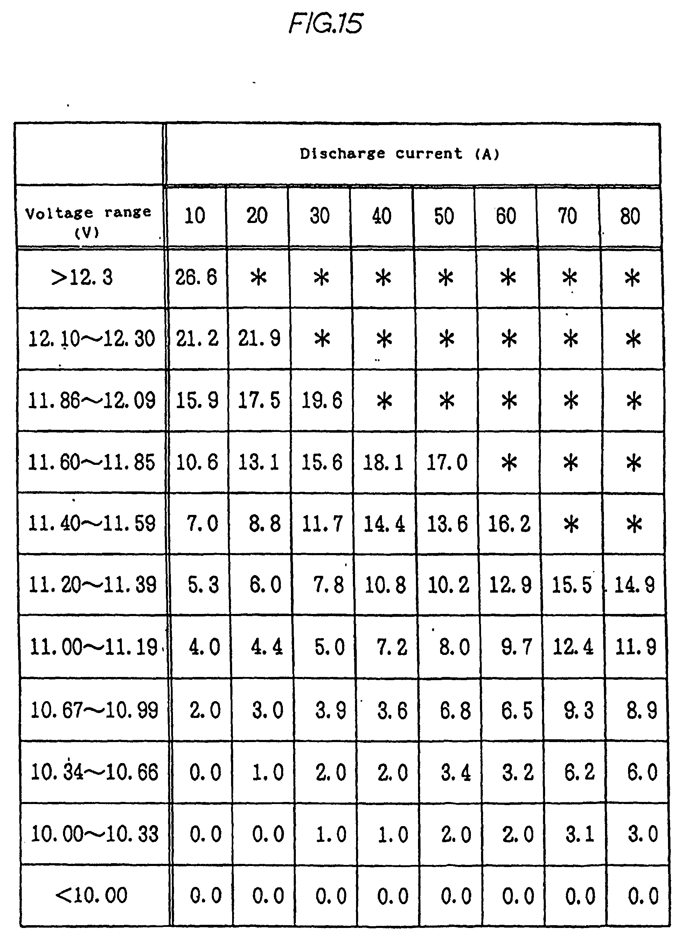

Thus, with respect to a battery having a capacity of 30Ah. a table for obtaining usable absolute capacity values of the battery can be obtained as shown in Fig. 15. Blocks (hereinafter referred to as cells) marked with an asterisk indicate that a combination of a given voltage and a given current cannot be attained.

In this invention, the absolute capacity values used in the aforementioned Fig. 15 are replaced by relative capacity values. And, as seen from the following examples and comparative examples, these relative values are used to realize a device which can simply determine the usable remaining capacity which varies according to the current values.

### (Example 1)

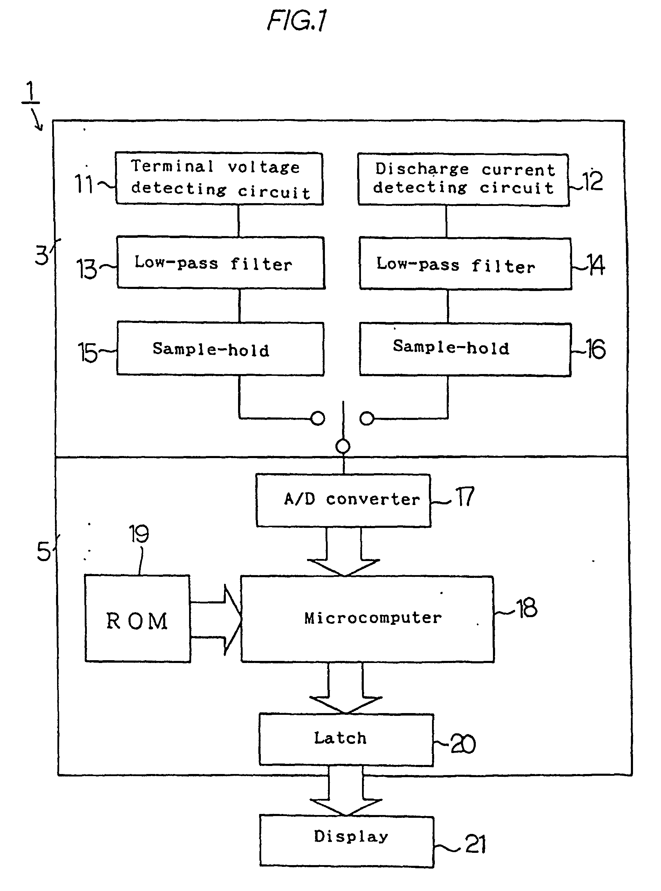

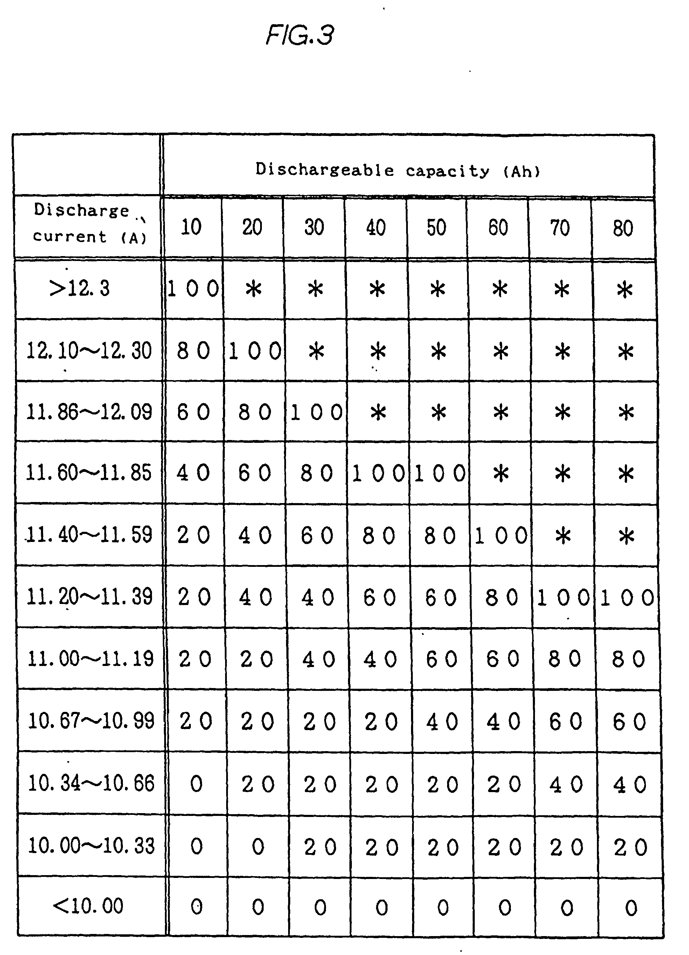

The battery remaining capacity meter of the invention will be described based on Example 1 shown in Fig. 1 and Fig. 3. Fig. 1 is the entire structural view of a device realizing the battery remaining capacity meter of this example. In the figure, a battery remaining capacity meter 1 comprises a detecting circuit block 3, a microcomputer block 5 connected to the above block, and a display 21 connected to the block 5.

Specifically, the detecting circuit block 3 is connected to the terminals of a battery which is not shown and comprises detecting circuits 11, 12 for detecting the battery current and voltage, filter circuits 13, 14 for filtering detection signals from these circuits 11, 12, and hold circuits 15, 16 for holding the filtered signals. And. the microcomputer block 5 comprises an A/D converter 17 for converting an analog signal from the detecting circuit into a digital signal, a microcomputer 18 for determining a battery remaining capacity value with reference to a table of a ROM 19 based on the digital signal, and a latch circuit for holding the remaining capacity value. The battery of this example is the aforementioned sealed lead acid battery having a nominal capacity of 30Ah to simplify the description.

The above detecting circuits 11, 12 are connected to the battery terminals to detect the terminal voltage and the discharge current of the battery being used. Specifically, the terminal voltage is easily detected by resistance division. On the other hand, a discharge current can be detected by either a method using a shunt resistance connected in series with a load of the battery or a method using a current sensor with a Hall element.

These detected terminal voltage and discharge current have an a.c. component removed by low-pass filters 13, 14. This is due to a fact that the discharge characteristic of the battery is controlled by a phenomenon with a very slow rate of diffusion of the electrolyte and depends on an average discharge current value.

The detected analog signal having the a.c. component removed is converted into a digital signal by an A/D converter 17 through sample-hold circuits 15, 16 and outputted to the microcomputer 18.

The microcomputer 18 reads the terminal voltage value and the discharge current value converted into the digital signal and obtains the remaining capacity value corresponding to a combination thereof from the ROM 19. The ROM (read-only memory) 19 has a data table of the remaining capacity value, to be described afterward, prepared based on values measured in advance and stored. And the microcomputer 18 outputs binary data corresponding to the obtained remaining capacity value to a latch circuit 20. The binary data is data decoded to cause for example a display 21 to appropriately indicate the increase or decrease in the remaining capacity value.

The latch circuit 20 is structured to hold the last data until new data comes from the microcomputer 18 and is output to the display 21.

The display 21 indicates the increase or decrease of the remaining capacity value according to the data held in the latch circuit 20. A driving battery for electric-motor vehicles may be charged by regenerative braking when running. When charging, the remaining capacity value cannot be obtained from the data table in the ROM 19 because the battery is not discharged, and the discharge current and voltage values cannot be detected. Therefore, data of the microcomputer 10 is not outputted to the latch circuit 20 during this regeneration period. Accordingly, it is structured that during the period of regenerative braking, the remaining capacity value immediately before the regenerative braking is held and this remaining capacity value is indicated on the display 21.

It does not matter whether or not regenerative braking can be detected according to a positive or negative current value, if an indication is used that regenerative braking is occurring by reasons of a separately received signal from a control circuit of the electric-motor vehicle.

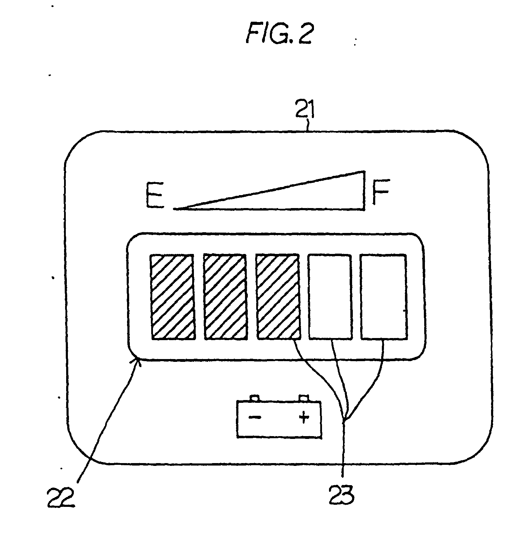

In this example, the display 21 is provided with an LED module 22 consisting of five LEDs as shown in Fig. 2. These LEDs are arranged in a horizontal direction and designed to increase or decrease the number of illuminated LEDs from the left side in the figure according to the decoded data from the latch circuit 20. Specifically, when the remaining capacity value is 80% or more, the remaining capacity is determined to be F (full) and the display illuminates all five LEDs of the LED module 22. Similarly, when the remaining capacity value is 60% or more and less than 80%. four LEDs are illuminated. Thus, the number of illuminated LEDs is decreased by one at every 20%, and 0% or below is determined to be E (empty). In this condition, all LEDs are turned off. Therefore, in Fig. 2, three LEDs are illuminated, indicating that the battery remaining capacity at a certain current used is 40% or more and less than 60%.

This invention is not limited to the indication of the increase or decrease of the illuminated number of LEDs of the display 21, but it may be structured to indicate by the increase or decrease of the display range, by a change of brightness, or by a change of a color.

The above circuit structure is merely one example. and it may be a more simplified circuit structure by for example subjecting the detection data read in the microcomputer 18 to a digital low-pass filtering, so that the low-pass filters 13, 14 can be omitted. Further, the sample-hold circuits 15, 16 may be one sample-hold circuit which is switched by time-sharing, so that further simplification can be made.

In addition, for the indication of the increase or decrease by the display, when a D/A converter is used at the downstream of the latch circuit, an analog voltmeter may be used as the display.

Further, it is to be understood that making modifications to the indicating method, such as giving an allowance to the indication by allowing the display to indicate the battery exhaustion state E (empty) before reaching the remaining capacity 0% thereby securing safety, does not depart from the invention.

The data table stored in the ROM 19 is prepared from the actually measured data shown in Fig. 15 and has the characteristic that a relative value is used instead of an absolute capacity value.

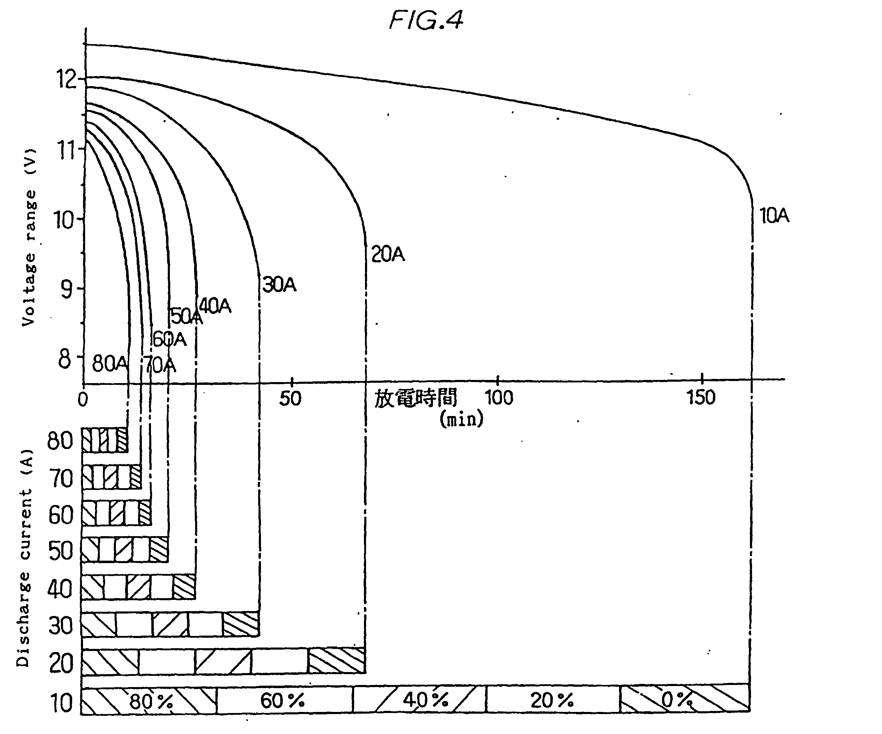

Specifically, in the data table shown in Fig. 3, after defining the maximum capacity value of each row as 100%, other values shown in the lower cells in the same column are defined and set as a percentage of the maximum capacity value. Specifically, the maximum capacity value at each discharge current is determined to be 100%, and the remaining capacity value determined from this current value and the detection voltage at this time is indicated as a percentage with respect to the maximum capacity value. Based on a discharge curve of voltage with respect to time for a given current value measured from an actual battery as shown in Fig. 14. the total discharge time of the time axis is divided according to the indicated percentages, and a voltage range corresponding to the division is determined. In other words, since the usable whole capacity varies according to each discharge current as shown in Fig. 4, according to this variable total capacity, the remaining capacity value at the discharge current for a given time is defined relatively as a percentage of the total capacity for a given current.

Advantages of the battery remaining capacity meter using relative capacity values will be described with reference to the following examples.

First, when a fully charged battery is discharged at a low discharge current of 10A, and then the discharge current is increased to 80A, the voltage detection value decreases, and moves from a cell of 10A-12.3V to a cell of 80A-11.2 to 11.39V in the data table of Fig. 3. The remaining capacity value of both cells has a value of 100%, and the remaining capacity meter indicates 100%. The indication by the remaining capacity meter is constant regardless of the magnitude of the discharge current since the remaining capacity is in the fully charged state. Therefore, even when the discharge current is quickly brought back to 10A, the remaining capacity indication does not change and remains as 100%. And, after the passage of a predetermined time under this discharge condition, when the detected current-voltage value becomes 10A-12.1 to 12.3V, the remaining capacity indication lowers to 80%, but when the current is increased to 80A, the voltage lowers to 11.0 to 11.19V, and the corresponding remaining capacity value remains the same at 80%. Thus, even when one discharge current changes to another discharge current, the indication of 80% capacity is the same and the indication itself is continuously indicated. Similarly, once 0% is reached at any discharge current and the indication value of its cell becomes 0%, when the discharge current is changed, the voltage range also changes, and a cell indicating the remaining capacity moves, but the indicated value of the cell remains 0%. Specifically, as shown in Fig. 3, the change of the indicated value due to the movement between cells in adjacent columns is horizontal or on a diagonal line and is continuously smooth such that the indication does not change suddenly, preventing the user from being confused unnecessarily.

The above structure of the invention allows measurements of remaining capacity regardless of the presence or absence of a load.

As shown above, differences in dischargeable capacity due to the magnitude of the battery discharge current value are automatically corrected, and the dischargeable capacity with respect to the present discharge current value can always be indicated correctly. And, since the battery is not over-discharged, the degradation of battery performance due to a careless misuse can be prevented, and the battery performance can be maximized.

Further, the realization of the battery remaining capacity meter in a simple circuit structure can improve cost efficiency.

In addition, the battery remaining capacity meter of the invention has an advantage that it is not necessary to make a temperature compensation due to a change of the electrolyte temperature in view of its operation. When the electrolyte temperature lowers, the battery terminal voltage decreases with the decrease of the electromotive force and the increase of the internal resistance, and the rate of decrease of the terminal voltage is accelerated for a constant current discharge because the rate of electrolyte diffusion is slowed. With the battery remaining capacity meter of the invention, these phenomena are automatically corrected as a decrease of the remaining capacity value as the rate of decrease of the terminal voltage accelerates. Also, the degradation of the battery performance can be recognized as a reduction of the remaining capacity after full charging.

Furthermore, since a measured value immediately before the in-flow of an electric current to the battery is held and indicated for a period during which the electric current flows into the battery, it can handle the regenerative charge from regenerative braking in electric motor vehicles and related applications.

As described above, since the usable battery remaining capacity decreases with the increase of a battery discharge current, a remaining capacity meter, which uses a current value as one of several variables for determining the remaining capacity, it needs to incorporate a function for correcting the indication of a remaining capacity according to increases or decreases in the electric current. This invention measures both a discharge current and a terminal voltage of a battery to determine the remaining capacity. According to a combination of these measured current and voltage values, a ratio of the usable remaining capacity at that current value is determined with reference to the remaining capacity value stored in table form in the memory. Specifically, the remaining capacity values stored in the data table of the invention correspond to relative values. A range indicating the relative remaining capacities ranges from 100% for the fully charged battery to 0% for the battery in the empty state. The dischargeable capacity at each discharge current is determined by discharging the battery from the fully charged state to the cut-off voltage of the empty state. The dischargeable capacity at each current is divided at equal intervals such as 100%, 90%, 80%, 70%, 60%, 50%, 40%, 30%, 20%, 10%, and 0%. The measured voltage at each uniform division point and the discharge current corresponding to it form one horizontal row of Fig. 3. Therefore, using the relative remaining capacity values (0 to 100%) of the invention, for the change of indication by the remaining capacity meter as a function of electric current, it can be clearly seen that the rate of decrease of the indicated values from 100% to 0% will be accelerated with increasing current. Thus, since a method, for correcting for capacity change as a function of electric current by the changing rate of decrease of the remaining capacity indicating values, is incorporated into the battery capacity meter, the value indicated as the battery remaining capacity value can be easily understood and grasped by the user. This is because its function is very similar to that of a fuel meter used in conventional internal combustion engine cars.

### (Example 2)

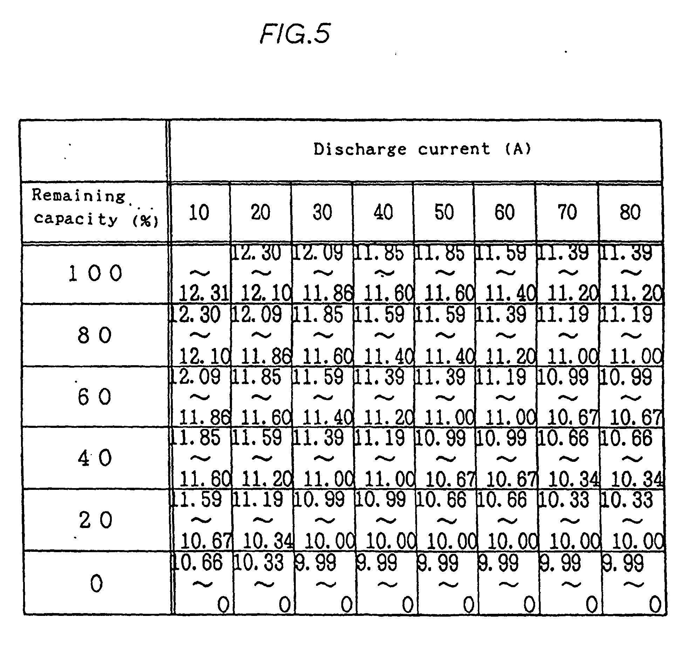

The battery remaining capacity meter of the invention will be described based on Example 2 shown in Fig. 5. The battery remaining capacity meter of this example has the same structure as that of Example 1 except that the data table stored in the memory means, ROM, is changed.

Specifically, as shown in Fig. 5, this data table is prepared by modifying the data table of Fig. 3 used in Example 1. and consists of current values of the operating battery in the horizontal direction and percent divisions corresponding to the indication division of the display means in the vertical direction. And, each block divided by these current values and percentage covers a voltage range meeting the percentage condition at each current from the data table of Fig. 5. When the battery is being used, the battery remaining capacity is determined from the voltage value detected at the current used with reference to the table. Specifically, it is structured that the reference row of the table is determined from the current used, a block is determined from the applicable detected voltage value in this reference row, and the remaining capacity percentage line corresponding to this block is determined.

Therefore, the same effects as in the former example can be attained, and the volume of data can be reduced. enabling simplification.

### (Example 3)

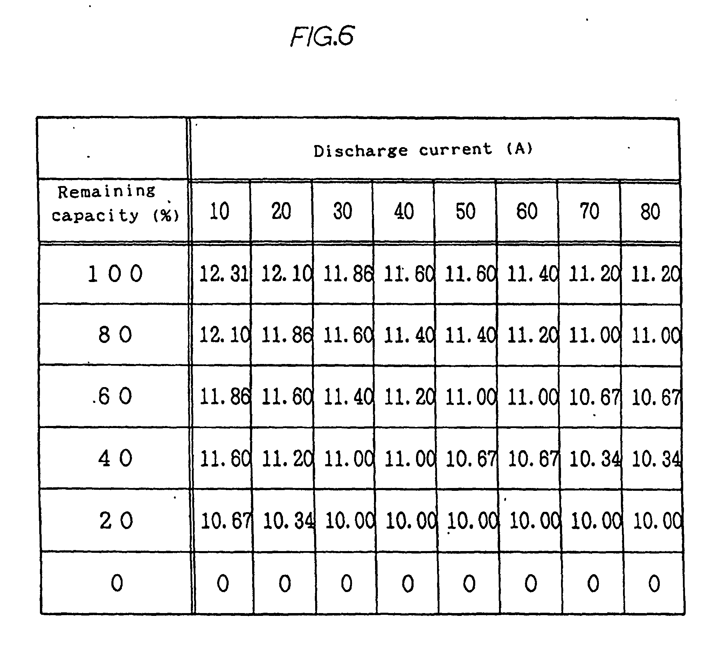

Further. the battery remaining capacity meter of the invention will be described based on Example 3 shown in Fig. 6. The battery remaining capacity meter of this example has the same circuit structure as that of Example 1 and Example 2 except that the data table stored in the memory means, ROM, is changed.

Specifically, as shown in Fig. 6, this data table has the same structure as the data table of Example 2, and the voltage value of each block is the lower limit value of each corresponding block used in the data table of Example 2. And, when the battery is being used, the battery remaining capacity is determined from the voltage value detected at the current used with reference to the table. Specifically. the reference row of this table is first determined from the current used. Then, the detected voltage value and the voltage value of each block are compared, and the block Pn which meets the condition, Pn<detected voltage value<Pn+1, is determined as the applicable block. Lastly, the remaining capacity percentage corresponding to the applicable block is determined, and the increase or decrease corresponding to this percentage is indicated on the display.

Therefore, the same effects as in the former example can be attained, and the volume of data can be reduced, enabling simplification.

### (Example 4)

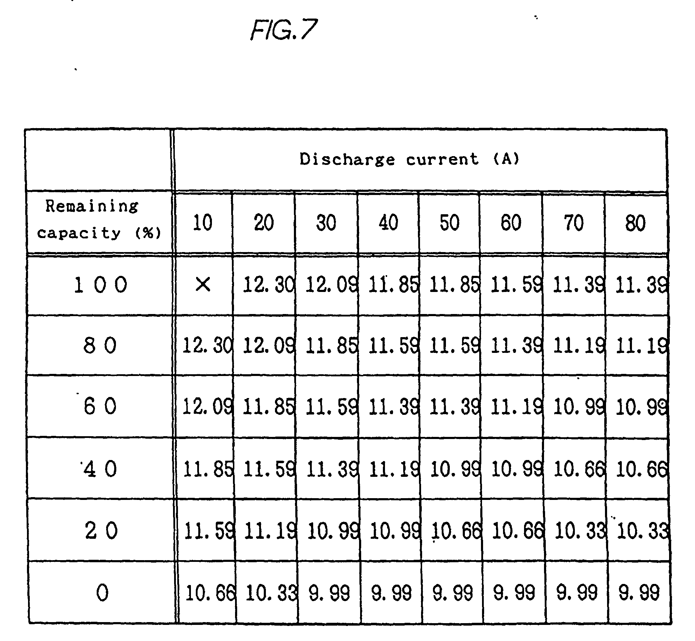

Further, the battery remaining capacity meter of the invention will be described based on Example 4 shown in Fig. 7. The battery remaining capacity meter of this example has the same circuit structure as that of Example 1 except that the data table stored in the ROM 19 is changed.

Specifically, as shown in Fig. 7, this data table has the same structure as the data table of Example 2, and the voltage value of each block is the upper limit value of each corresponding block used in the data table of Example 2. And, when the battery is being used, the battery remaining capacity is determined from the voltage value detected at the current used with reference to the table. Specifically, the reference row of this table is first determined from the current used. Then, the detected voltage value and the voltage.value of each block are compared, and the block Pn which meets the condition. Pn<detected voltage value<Pn+1. is determined as the applicable block. Lastly, the remaining capacity percentage corresponding to the applicable block is determined, and the increase or decrease corresponding to this percentage is indicated on the display.

Therefore, in the same way as Example 3, the volume of data can be reduced, enabling simplification.

### (Comparative Example 1)

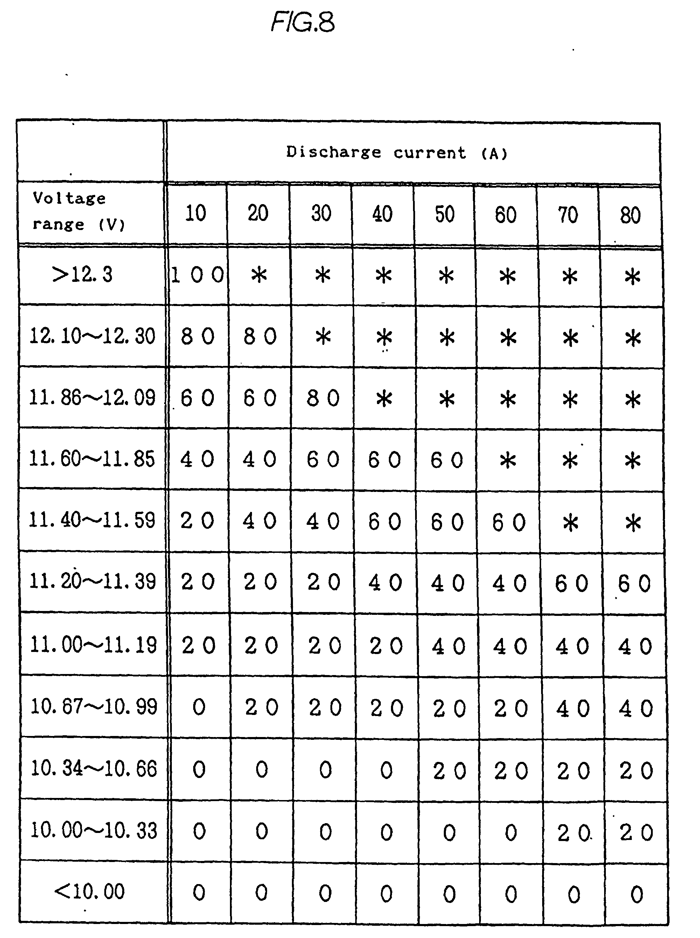

Now. Comparative Example 1 will be described with reference to Fig. 8. The same circuit structure of the battery remaining capacity meter as that shown in Fig. 1 of this invention will be used in this Comparative Example 1. The same display as that shown in Fig. 5 and used in Example 1 will be used. In addition, as described in Example 1, the structure for retaining the remaining capacity value immediately before the regenerative braking will be used in this Comparative Example 1.

Specifically, the data table stored in the memory, ROM 19, is prepared based on the absolute capacity data of Fig. 15. But, to indicate the remaining capacity using five LED modules, it is necessary to correct the obtained absolute capacity value into a percentage ranging from 0% to 100%. Specifically, when the maximum value (26.6Ah at a constant discharge rate of 10Ah) of the absolute capacity is defined as 100%, other values in the table are set as a percentage of this maximum capacity value. The data table thus obtained and actually stored in the ROM 19 is shown in Fig. 8.

Disadvantages of using absolute capacity values will be shown for the operating conditions described below. First. a fully charged battery is discharged at a low discharge rate of 10A, and then the discharge rate is increased to 80A. In this case, since the absolute capacity value varies according to the discharge current, the indication of the remaining capacity meter is switched from 100% when discharged at 10A to 60% at 80A. And, when the discharge current is quickly brought back to 10A, the indication suddenly returns to 100% while passing through a state of 80%. Further, after the passage of a predetermined time under this discharging condition, the indication is reduced by one unit (20%). Although the indication remains same when the relative capacity value is used, in this case when the absolute capacity value is used, the display corresponds to the measured current-voltage, indicating 80% at a 10A discharge current (12.1 to 12.3V) and 40% at an 80A discharge current (11.0 to 11.19V). After reaching the 0% limit, regardless of the discharge current, the indication becomes 0% at all current levels. In general, the display indicates drastic changes in the capacity indicating value for different current values when the battery is fully charged or nearly fully charged. The drastic changes in the capacity indicating value due to a change of the current value becomes less drastic only as the battery gets closer to the empty state. Thus, on the whole. it is difficult for the user to understand the condition of the battery from this display.

### (Comparative Example 2)

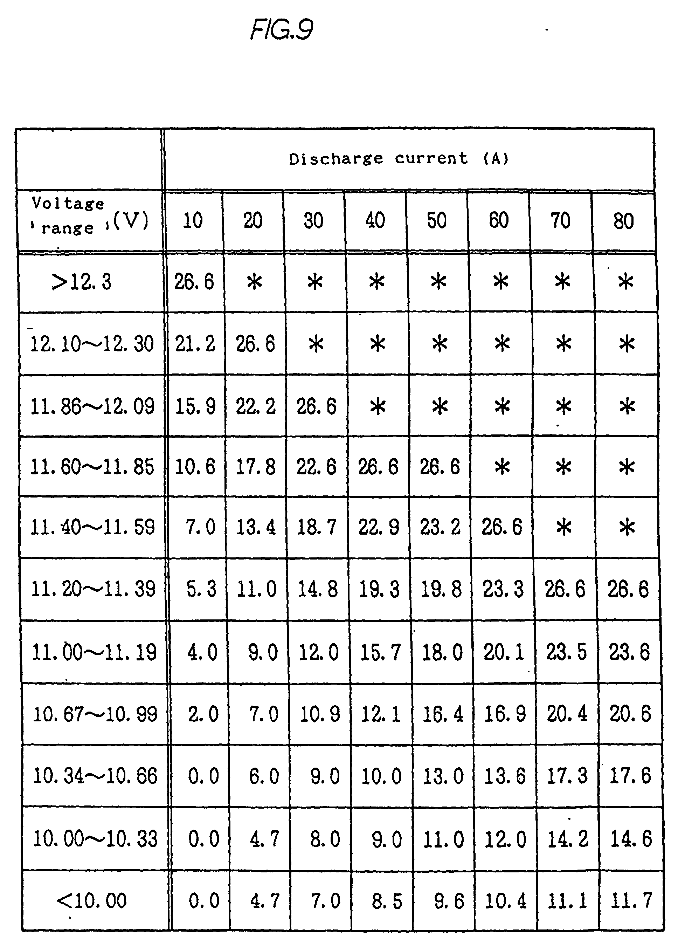

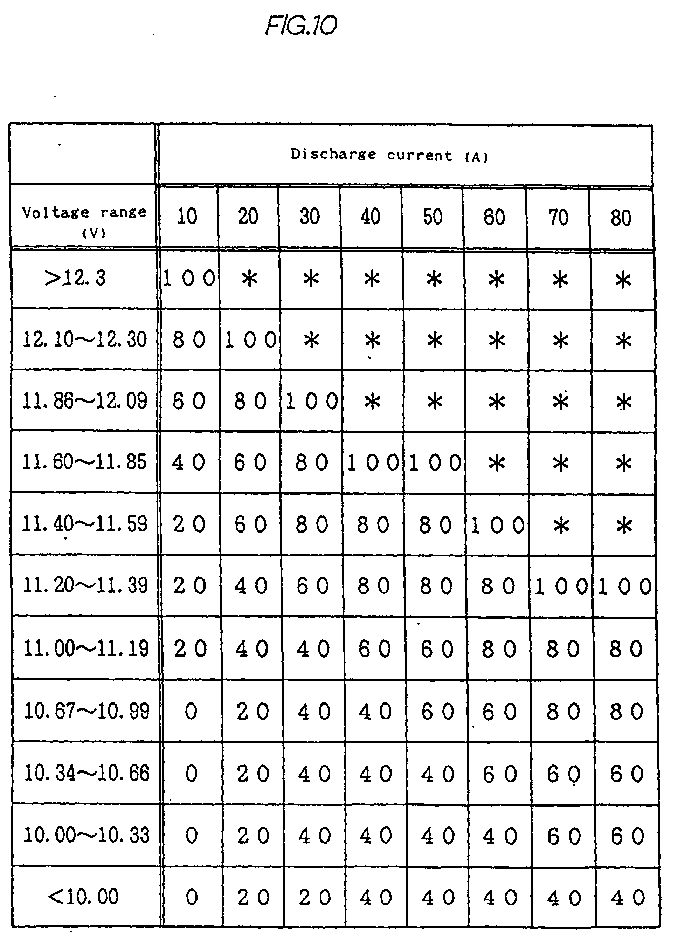

Comparative Example 2 will be described with reference to Fig. 9 and Fig. 10. Comparative Example 2 uses the same circuit structure and display as in Example 1 of the invention. Therefore, the remaining capacity value immediately before regenerative braking is retained during the regenerative braking.

Specifically, the data table stored in the ROM 19 is prepared from the absolute capacity data of Fig. 9. First. the maximum capacity at each discharge current is defined again as 26.6Ah. This value is the maximum capacity within a range of current actually used. For the absolute capacity data defined in this way, when the discharge current is high, remaining capacity is indicated even after the cut-off voltage is reached and capacity cannot be withdrawn at this high current.

As described in Comparative Example 2, to indicate the remaining capacity by five LED modules, it is necessary to scale the absolute capacity value to a percentage of 0% to 100%. Specifically, when the maximum absolute capacity value 26.6Ah is defined as 100%, other values in the figure are determined as a percentage of this maximum capacity value. Data obtained as a result and actually stored in the ROM 19 is shown in Fig. 10.

Disadvantages of using the percentage indication of the absolute capacity value shown in Fig. 10 will be shown for the operating conditions described below. First, a fully charged battery is discharged at a low current discharge of 10A, and then at a large current discharge of 80A. In this case. when the maximum value of absolute capacity in each row of the table is defined as 100% regardless of the magnitude of the discharge current, the remaining capacity meter can indicate 100% at both of 10A discharge and 80A discharge. Specifically, even when the 80A discharge is quickly returned to 10A, the indicated value does not vary from 100%. And, after the passage of a predetermined time under this discharge condition, the indicated value is reduced by one unit (20%). It is easily seen that the remaining capacity indication output as a function of the current does not change drastically at this point. In this case, this is a result of the way in which the absolute capacity data is defined.

However, when the battery is continuously discharged at a high discharge rate for a long period and then discharged at a low discharge rate, it can be recognized that the capacity reduces by one unit when the current is reduced to the lower rate. The disadvantage of using the absolute capacity value based on Fig. 10 becomes apparent as the battery gets closer to an empty state. Specifically, as seen from Fig. 10, when the battery is discharged at a high current rate, the actual battery capacity will reach the empty state even though the display value indicates a remaining capacity value of 40%. And, when discharged at an intermediate discharge rate, the battery will reach the empty state even though the display indicates a remaining capacity value of 20%. Even when the display indicates that the battery has an effective capacity, such a capacity is not available. As a result, the display shows drastic changes in the capacity indicating value as a function of the discharge current when the battery approaches the empty state. The drastic changes in capacity due to a change of the current become less drastic only as the battery gets closer to the fully charged state. As an overall result, when the remaining capacity meter of this Comparative Example is used, it is difficult for the user to understand the indicated value of the remaining capacity.

### Industrial Applicability

The invention structured as described above is suitable for a remaining capacity meter of a battery used as a driving source for an electric motor vehicle such as an electric car.

## Claims

1. A battery remaining capacity meter which comprises:
a detecting means (3) for detecting the discharge current and the terminal voltage of a battery,
a data table of remaining capacity values of the battery, each of which corresponds to a respective combination of a discharge current and a terminal voltage, and in which the remaining capacity values are based on actual measurements,
a memory (19) for storing the above data table, and
an indicating means (18) for reading the remaining capacity value from the memory using the current value and the terminal voltage value of the operating battery and for controlling a display (21),
**characterized in that**:
the remaining capacity value defined as a percentage of the capacity of the battery in a fully charged state thereof is set as a ratio between a total time during which a constant current discharge can be made from an initial voltage in a fully charged state to an end voltage and a remaining time during which the constant current discharge can be made from the detected terminal voltage value to the end voltage.

2. A battery remaining capacity meter according to Claim 1, wherein the table stored in said memory (19) has each current value corresponding to usable conditions in one span of the table and a voltage value division divided into several small ranges corresponding to each current value in the other span of the table.

3. A battery remaining capacity meter according to Claim 2, wherein the remaining capacity values corresponding to current values in said table has the maximum capacity value of each row defined as 100%, and other values in the same row defined as a percentage ratio with respect to the maximum capacity value.

4. A battery remaining capacity meter according to Claim 3, wherein said display means (21) is provided with a prescribed number of light emission elements (23) and increases or decreases in the number of active light emission elements corresponding to the magnitude of said remaining capacity value.

5. A battery remaining capacity meter according to Claim 4, wherein said remaining capacity value of from 0 to 100% is divided into a plurality of groups, the number of said groups agrees with the number of said light emission elements (23), and increases or decreases in the number of active light emission elements corresponding to the magnitude of said remaining capacity value.

6. A battery remaining capacity meter according to Claim 1, wherein the remaining capacity value is determined from the terminal current and voltage value immediately before the in-flow of an electric current to the battery for a period during which the electric current flows into the battery by power regeneration.

## Patentansprüche

1. Batterierestkapazitätsmesser, der umfasst:
ein Erfassungsmittel (3) zum Erfassen des Entladestroms und der Anschlussspannung einer Batterie,
eine Datentabelle von Restkapazitätswerten der Batterie, von denen jeder einer jeweiligen Kombination eines Entladestroms und einer Anschlussspannung entspricht und in der die Restkapazitätswerte auf tatsächlichen Messungen basieren,
einen Speicher (19) zum Speichern der obigen Datentabelle, und
ein Anzeigemittel (18) zum Lesen des Restkapazitätswertes von dem Speicher unter Verwendung des Stromwerts und des Anschlussspannungswerts der betriebenen Batterie und zum Steuern einer Anzeige (21),
**dadurch gekennzeichnet, dass**:
der als ein Prozentsatz der Kapazität der Batterie in deren vollgeladenen Zustand definierte Restkapazitätswert eingestellt ist als ein Verhältnis zwischen einer Gesamtzeit, während der eine konstante Stromentladung ausgeführt werden kann von einer Ausgangsspannung in einem vollgeladenen Zustand zu einer Endspannung und einer Restzeit, während der die konstante Stromentladung ausgeführt werden kann von dem erfassten Anschlussspannungswert zu der Endspannung.

2. Batterierestkapazitätsmesser nach Anspruch 1, wobei die in dem Speicher (19) gespeicherte Tabelle jeden verwendbaren Bedingungen entsprechenden Stromwert in einem Bereich der Tabelle hat und eine Spannungswertunterteilung, aufgeteilt in einige kleine Bereiche entsprechend jedem Stromwert in dem anderen Bereich der Tabelle.

3. Batterierestkapazitätsmesser nach Anspruch 2, wobei die Stromwerten entsprechenden Restkapazitätswerte in der Tabelle den maximalen Kapazitätswert jeder Reihe als 100% definiert haben und andere Werte in derselben Reihe als Prozentverhältnis in Bezug auf den maximalen Kapazitätswert definiert haben.

4. Batterierestkapazitätsmesser nach Anspruch 3, wobei das Anzeigemittel (21) mit einer vorgeschriebenen Anzahl von Lichtemissionselementen (23) versehen ist und die Anzahl der aktiven Lichtemissionselemente erhöht oder abnimmt entsprechend der Größe des Restkapazitätswerts.

5. Batterierestkapazitätsmesser nach Anspruch 4, wobei der Restkapazitätswert von 0 bis 100% aufgeteilt ist in eine Vielzahl von Gruppen, die Anzahl der Gruppen übereinstimmt mit der Anzahl der Lichtemissionselemente (23) und die Anzahl der aktiven Lichtemissionselemente zunimmt oder abnimmt entsprechend der Größe des Restkapazitätswerts.

6. Batterierestkapazitätsmesser nach Anspruch 1, wobei der Restkapazitätswert bestimmt wird aus dem Anschlussstrom und dem Spannungswert unmittelbar vor dem Hineinfließen eines elektrischen Stroms in die Batterie für eine Zeitdauer während der der elektrische Strom in die Batterie fließt durch Leistungsregeneration.

## Revendications

1. Appareil de mesure de capacité de batterie restante qui comprend :
un moyen de détection (3) pour détecter le courant de décharge et la tension de borne d'une batterie,
une table de données des valeurs de capacité restante de la batterie, dont chacune correspond à une combinaison respective d'un courant de décharge et d'une tension de borne, et dans laquelle les valeurs de capacité restante sont basées sur des mesures actuelles,
une mémoire (19) pour mémoriser la table de données ci-dessus, et
un moyen d'indication (18) pour lire la valeur de capacité restante dans la mémoire en utilisant la valeur du courant et la valeur de la tension de borne de la batterie en fonctionnement et pour commander un affichage (21),
**caractérisé en ce que** :
la valeur de capacité restante définie comme un pourcentage de la capacité de la batterie à son état totalement chargé est fixée comme un rapport entre une durée totale pendant laquelle une décharge à courant constant peut être effectuée à partir d'une tension initiale à un état totalement chargé jusqu'à une tension de fin et une durée restante pendant laquelle la décharge à courant constant peut être effectuée à partir de la valeur de tension de borne détectée jusqu'à la tension de fin.

2. Appareil de mesure de capacité de batterie restante selon la revendication 1, dans lequel la table mémorisée dans ladite mémoire (19) comporte chaque valeur de courant correspondant à des conditions d'utilisation dans une dimension de la table et une division de valeur de tension divisée en de nombreuses petites plages correspondant à chaque valeur de courant dans l'autre dimension de la table.

3. Appareil de mesure de capacité de batterie restante selon la revendication 2, dans lequel les valeurs de capacité restante correspondant aux valeurs du courant dans ladite table comporte la valeur de capacité maximale de chaque rangée définie comme 100 %, et les autres valeurs dans la même rangée définies comme un rapport de pourcentage par rapport à la valeur de capacité maximale.

4. Appareil de mesure de capacité de batterie restante selon la revendication 3, dans lequel ledit moyen d'affichage (21) est muni d'un nombre prescrit d'éléments à émission de lumière (23) et augmente ou diminue le nombre des éléments à émission de lumière actifs en correspondance avec la grandeur de ladite valeur de capacité restante.

5. Appareil de mesure de capacité de batterie restante selon la revendication 4, dans lequel ladite valeur de capacité restante de 0 à 100 % est divisée en une pluralité de groupes, le nombre desdits groupes concorde avec le nombre desdits éléments à émission de lumière (23), et augmente ou diminue le nombre des éléments à émission de lumière actifs en correspondance avec la grandeur de ladite valeur de capacité restante.

6. Appareil de mesure de capacité de batterie restante selon la revendication 1, dans lequel la valeur de la capacité restante est déterminée à partir du courant de borne et de la valeur de tension immédiatement avant l'alimentation d'un courant électrique à la batterie pendant une durée pendant laquelle le courant électrique circule dans la batterie par régénération d'énergie.
